# EUROPÄISCHE PATENTANMELDUNG

(11) **EP 3 136 539 A1**
(43) Veröffentlichungstag der Anmeldung: **01.03.2017**
(21) Anmeldenummer: 16190154.1
(22) Anmeldetag: 09.09.2013
(51) Int. Cl.: H02J 7/00, H02J 7/04, H01M 10/44, H01M 10/06, H02J 7/10

(54) **VERFAHREN UND VORRICHTUNG ZUM LADEN VON BATTERIEN**

(30) Priorität: 13.09.2012 AT 503822012
(62) Teilanmeldung aus: 13791898.3
(71) Anmelder: Fronius International GmbH, 4643 Pettenbach (AT)
(72) Erfinder: BINDER, Jürgen, 4644 Scharnstein (AT); EITELSEBNER, David, 4564 Klaus (AT)
(74) Vertreter: Sonn & Partner Patentanwälte

(57) **Zusammenfassung**

Die Erfindung betrifft ein Verfahren und eine Vorrichtung zum Laden von Batterien, insbesondere Bleisäurebatterien, mit einer vorgegebenen Ladeschlussspannung (U_{LS}), wobei vor dem Ladevorgang der Ladezustand der Batterie (10) festgestellt wird, und die Batterie (10) während des Ladevorgangs mit einem Ladestrom (I_{L}) oder einer Ladespannung (U_{L}) beaufschlagt wird. Zur Erzielung einer möglichst effizienten und schonenden Ladung der Batterie (10) und Erhöhung der Lebensdauer der Batterie (10) ist vorgesehen, dass die Ladespannung (U_{L}) während einer vorgegebenen Ladezeit (t'_{Laden}) durch eingeprägte Strompulse oder Spannungspulse zwischen einer Ladestartspannung (U_{LA}) gemäß dem Ladezustand der Batterie (10) und der Ladeschlussspannung (U_{LS}) schrittweise erhöht wird und in den Pausen zwischen zwei Strompulsen oder Spannungspulsen der Innenwiderstand (R_{I}) der Batterie (10) gemessen wird, und der Ladestrom (I_{L}) oder die Ladespannung (U_{L}) so geregelt wird, dass der Ladestrom (I_{L}) oder die Ladespannung (U_{L}) an den gemessenen Innenwiderstand (R_{I}) angepasst wird.

## Beschreibung

Die Erfindung betrifft ein Verfahren und eine Vorrichtung zum Laden von Batterien, insbesondere Blei-Säure-Batterien, mit einer vorgegebenen Ladeschlussspannung, wobei vor dem Ladevorgang der Ladezustand der Batterie festgestellt wird, und die Batterie während des Ladevorgangs mit einem Ladestrom oder einer Ladespannung beaufschlagt wird.

Prinzipiell ist die gegenständliche Erfindung für das Laden verschiedenster aufladbarer Batterien bzw. Akkumulatoren, beispielsweise Blei-Säure-Batterien, Lithiumbatterien, Nickel-Metallhydrid (NiMH)-Batterien und viele mehr, geeignet. Bei Blei-Säure-Batterien, wie sie beispielsweise für elektrisch angetriebene Fahrzeuge eingesetzt werden, ist das erfindungsgemäße Ladeverfahren und die erfindungsgemäße Ladevorrichtung wegen der hohen Abhängigkeit des Innenwiderstands derartiger Batterien vom Ladezustand, jedoch besonders vorteilhaft.

Bei elektrisch betriebenen Fahrzeugen oder Transportmitteln, wie zum Beispiel sogenannten Flurförderzeugen (Stapler, Hubwagen, etc.), die häufig im Schichtbetrieb eingesetzt werden, ist eine regelmäßige Ladung der Batterien zwischen den Betriebs- oder Schichtzeiten erforderlich. Üblicherweise erfolgt die Ladung der Batterien unabhängig von deren Ladezustand. Der Innenwiderstand von Batterien, insbesondere jener von Blei-Säure-Batterien, weist aufgrund der chemischen Vorgänge in den Zellen der Batterie eine starke Abhängigkeit vom jeweiligen Ladezustand auf. Insbesondere ist der Innenwiderstand bei geringer Ladung der Batterie höher, weist bei einem mittleren Ladezustand ein Minimum auf und steigt dann in Abhängigkeit des Ladezustands wieder an. Darüber hinaus ist der Innenwiderstand von Batterien auch stark abhängig von der Betriebstemperatur und vom Alter der Batterie.

Übliche Batterieladevefahren nehmen auf den jeweiligen Ladezustand der Batterie und den momentanen Innenwiderstand keine Rücksicht, weshalb keine optimale und schonende Ladung der Batterie resultiert und damit auch die Lebensdauer der Batterie herabgesetzt wird. Häufig werden die Batterien mit konstantem Ladestrom geladen. Beispielsweise beschreibt die EP 2 244 329 A1 ein Ladeverfahren zum Laden einer Batterie einer unterbrechungsfreien Spannungsversorgung, wobei die Ladeparameter bei Temperaturänderungen und dem Batteriealter entsprechend dynamisch angepasst werden.

Während des Ladens mit konstantem Ladestrom bei einer entladenen Batterie ist anfangs der Innenwiderstand der Batterie groß, weshalb es zu einer erhöhten Erwärmung der Batterie und in der Folge zu einer Alterung derselben kommt.

Verbesserungen können erzielt werden, wenn die aktuelle Ladespannung der Batterie beim Ladevorgang berücksichtigt wird. Beispielsweise beschreiben die WO 96/16460 A1 oder die DE 10 2009 051 731 A1 derartige Batterieladeverfahren und -vorrichtungen.

Die JP 2008-061373 A betrifft ein Ladeverfahren und eine Ladevorrichtung, bei welchem die Batterie mit konstanten Strom geladen wird.

Die EP 1 104 074 A1 beschreibt eine Schaltung zur Spannungsbegrenzung, welche parallel zu einer Batterie angeordnet wird, um eine verbesserte Ladung derselben zu erzielen.

Aus der US 2010/0066309 A1 ist ein Verfahren zum gepulsten Laden von Batterien mit konstantem Strom bekannt geworden.

Insbesondere beim Laden der Batterien von Flurförderzeugen steht meist eine definierte Ladezeit zum Laden der Batterien zwischen den einzelnen Arbeitsschichten verschiedener Schichtmodelle zur Verfügung. Dadurch, dass jedoch weder auf den aktuellen Ladezustand noch auf das Alter der Batterie Rücksicht genommen wird, kommt es regelmäßig zu einer übermäßigen Erwärmung der Batterie und somit zu erhöhter Alterung (Arrhenius-Gesetz). Die in der Batterie ablaufenden chemischen Reaktionen werden daher nicht optimal ausgenützt.

Die Aufgabe der vorliegenden Erfindung liegt daher in der Schaffung eines Verfahrens und einer Vorrichtung zum Laden einer Batterie, insbesondere Blei-Säure-Batterie, durch welche die Effizienz der Ladung und somit der Wirkungsgrad gesteigert und die Lebensdauer der Batterie verlängert werden kann. Insbesondere soll bei ausreichender Ladezeit eine optimale Ladung der Batterie ermöglicht werden. Nachteile bekannter Ladesysteme sollen verhindert oder zumindest reduziert werden.

Gelöst wird die erfindungsgemäße Aufgabe durch ein oben genanntes Verfahren zum Laden einer Batterie, wobei die Ladespannung während einer vorgegebenen Ladezeit durch eingeprägte Strompulse oder Spannungspulse zwischen einer Ladestartspannung gemäß dem Ladezustand der Batterie und der Ladeschlussspannung schrittweise erhöht wird, und in den Pausen zwischen zwei Strompulsen oder und Spannungspulsen der Innenwiderstand der Batterie gemessen wird, und der Ladestrom oder die Ladespannung so geregelt wird, dass der Ladestrom oder die Ladespannung an den gemessenen Innenwiderstand angepasst wird.. Vor dem eigentlichen Ladevorgang wird also der aktuelle Ladezustand der Batterie ermittelt und danach der Ladestrom oder die Ladespannung an diesen Ladezustand der Batterie und die eingestellte oder vorgegebene Ladezeit angepasst. Anstatt, dass mit konstantem Ladestrom unabhängig vom Ladezustand der Batterie geladen wird, nimmt das erfindungsgemäße Verfahren auf den tatsächlichen Ladezustand der Batterie und die mögliche Ladezeit Rücksicht und passt die Ladung an diese beiden Parameter entsprechend an. Dadurch, dass die Erhöhung der Ladespannung zwischen der Ladestartspannung und der Ladeschlussspannung der Batterie während der Ladezeit durch entsprechende Regelung des Ladestromes oder der Ladespannung erfolgt, wird indirekt auf den aktuellen Innenwiderstand der Batterie Rücksicht genommen. Somit erfolgt eine schonende Ladung der Batterie unter optimaler Ausnützung der zur Verfügung stehenden Ladezeit. In der Folge kommt es nur zu einer minimalen Erwärmung der Batterie und somit zu einer Minimierung der Alterung, wodurch die Lebensdauer der Batterie erhöht werden kann. Durch das erfindungsgemäße Verfahren sind Steigerungen des Ladewirkungsgrades im Bereich zwischen 5 und 15 % erreichbar. Das Verfahren lässt sich relativ leicht realisieren. Insbesondere moderne Batterieladegeräte mit integrierten Mikroprozessoren zur Steuerung der Ladevorgänge und entsprechender Regelgenauigkeit können im Wesentlichen durch bloße Software-Updates entsprechend umgerüstet werden. Die Ladestartspannung kann im einfachsten Fall der Leerlaufspannung der Batterie entsprechen oder einer Spannung, welche die Batterie aufweist, nachdem sie einen Prozess vor Durchführung des Ladeverfahrens, beispielsweise ein Depolarisationsverfahren, durchlaufen hat. Erfindungsgemäß wird der Ladestrom oder die Ladespannung derart geregelt, dass die Ladespannung während der Ladezeit zwischen der Ladestartspannung und der Ladeschlussspannung linear erhöht wird. Dies ermöglicht eine einfache Realisierung des Ladeverfahrens, indem eine Rampe der Ladespannung zwischen der Ladestartspannung und der Ladeschlussspannung über die vorgegebene Ladezeit erzeugt wird. Ist die Batterie beispielsweise zu Beginn mehr geladen, weist sie also eine höhere Spannung auf, wird die Steigung der Spannungsrampe reduziert, aber dennoch im Wesentlichen die volle Ladezeit ausgenützt. Dadurch dass die Spannungsrampe durch entsprechende Regelung des Ladestromes oder der Ladespannung realisiert wird, erfolgt auch eine automatische Einstellung auf den jeweiligen Innenwiderstand der Batterie. Abweichungen vom linearen Verlaufs der Ladespannung können für bestimmte Anwendungen von Vorteil sein und eventuell noch weitere Effizienzsteigerungen mit sich bringen. Die Regelung kann auch vorsehen, dass die Spannungsrampe in mehrere Teilrampen mit unterschiedlicher Steigung unterteilt wird, um beispielsweise das Auftreten eines zu hohen Ladestromes in der Phase des minimalen Innenwiderstands der Batterie auszugleichen.

Bei einem derartigen diskontinuierlichen Ladeverfahren kann noch besser auf den tatsächlichen Zustand der Batterie Rücksicht genommen und die Ladung mit optimaler Effizienz vorgenommen werden. Grundsätzlich kann der Ladevorgang sowohl durch eingeprägte Strompulse als auch durch eingeprägte Spannungspulse erfolgen, wobei die resultierende Ladespannung während der vorgegebenen Ladezeit zwischen der Ladestartspannung gemäß dem Ladezustand der Batterie und der Ladeschlussspannung erhöht wird. In den Pulspausen erfolgt die Messung des Innenwiderstands der Batterie. Beim Einprägen von Strompulsen kann dies durch Messung der Spannungsantwort, welche beim Reduzieren des Stromwerts auf einen vorgegebenen Wert oder auf Null resultiert, erfolgen.

Gemäß einem Merkmal der Erfindung wird eine Meldung ausgegeben, wenn der zur Erzielung der Ladespannung während der Ladezeit notwendige Ladestrom oberhalb eines maximal möglichen Ladestroms liegt. Reicht für die vorgegebene Ladezeit der Ladestrom nicht aus, würde die Batterie in dieser Ladezeit nicht vollgeladen werden können. Durch die Meldung kann der Benutzer darauf Rücksicht nehmen und beispielsweise die Ladezeit entsprechend erhöhen.

Dabei ist es von Vorteil, wenn ein entsprechender unterer Grenzwert für die Ladezeit angezeigt wird, innerhalb welchem das Laden der Batterie mit dem maximal möglichen Ladestrom bis zum Erreichen der Ladeschlussspannung möglich ist. Durch die Anzeige des unteren Ladezeit-Grenzwerts weiß der Benutzer, in welcher minimalen Zeit die Batterie wieder in vollgeladenem Zustand zur Verfügung stehen kann. Dies ist insbesondere bei der laufenden Verwendung von Batterien in einem Schichtbetrieb, beispielsweise beim Einsatz in Flurförderzeugen, von Relevanz.

Der Ladezustand der Batterie kann im einfachsten Fall durch Messung der aktuellen Leerlaufspannung festgestellt werden. Die aktuelle Leerlaufspannung kann dann als Ladestartspannung verwendet werden, oder es können Verfahren angewendet werden, welche die Batterie auf den Ladevorgang vorbereiten (beispielsweise Depolarisationsverfahren) und die dann resultierende Spannung der Batterie als Ladestartspannung herangezogen werden. Anstelle der Messung der aktuellen Leerlaufspannung zur Feststellung des Ladezustands der Batterie, kann dieser auch über Säuredichtebestimmung, Amperestundenbilanzierung oder Impedanzmessung durchgeführt werden.

Vorteile können erzielt werden, wenn die Batterie vor dem Ladevorgang depolarisiert wird, wenn die Leerlaufspannung unter einem vorgegeben Grenzwert liegt, indem der Ladestrom oder die Ladespannung derart geregelt wird, dass eine Spannungsrampe zwischen der Leerlaufspannung der Batterie und einer definierten Depolarisationsspannung erzeugt wird. Durch eine derartige Depolarisation kann ein "verschobenes" Elektrodenpotential einer Batterie wieder ins Gleichgewicht gerückt werden. Die nach dem Depolarisationsvorgang resultierende Spannung der Batterie entspricht dann der Ladestartspannung des Ladeverfahrens.

Die Depolarisations-Spannungsrampe kann zumindest einmal wiederholt werden. Die Dauer des Depolarisationsvorgangs wird als Bruchteil der zur Verfügung stehenden gesamten Ladezeit gewählt. Beispielsweise kann die Dauer der Depolarisation bei einer Ladedauer von einigen Stunden im Bereich weniger Minuten gewählt werden.

Nach erfolgtem Ladevorgang mit Erreichen der Ladeschlussspannung kann eine Nachladung zur Vollladung der Batterie vorgenommen werden. Für das Nachladen bzw. Vollladen der Batterie können verschiedene übliche Verfahren verwendet werden.

Anstelle der Eingabe der gewünschten Ladezeit kann auch die gewünschte Uhrzeit, zu welcher die Batterie vollgeladen sein soll, eingegeben oder vorgegeben werden und die Ladezeit als Differenz dieses vorgegebenen Endzeitpunkts des Ladevorgangs und der aktuellen Zeit ermittelt werden. Dies erleichtert die Handhabung des Ladegeräts, da der Benutzer die verfügbare Ladezeit nicht mehr berechnen muss, sondern bloß angeben muss, wann er die vollgeladene Batterie benötigt. Insbesondere bei einem Schichtbetrieb ist eine derartige Möglichkeit von Vorteil.

Die vorgegebene Ladezeit kann auf einen Bruchteil, insbesondere auf 50% bis 90% der vorgegebenen Ladezeit reduziert werden, um noch ausreichend Zeit für den allfälligen Depolarisationsvorgang oder andere Prozeduren zu haben. Auch wird durch eine derartige Verkürzung der definitiven Ladezeit sichergestellt, dass bereits vor dem vereinbarten Zeitpunkt die Batterie vollgeladen ist und beispielsweise vor einem Schichtbeginn rechtzeitig in ein Flurförderzeug eingebaut werden kann.

Wenn der Beginn des Ladevorgangs um eine Zeitspanne verzögert wird, kann beispielsweise ein wirtschaftlicher Vorteil durch Ausnützung billigeren Nachtstroms erzielt werden.

Dabei kann eine maximal mögliche Zeitspanne für die Verzögerung des Ladevorgangs vorgeschlagen und angezeigt werden. Dadurch kann dem Benutzer zum Beispiel die Möglichkeit der Ausnützung billigeren Nachtstroms angeboten werden. Dieser muss die Verzögerung dann durch entsprechende Betätigung an der Batterieladevorrichtung einstellen.

Gelöst wird die erfindungsgemäße Aufgabe auch durch eine oben genannte Batterieladevorrichtung, bei der die Steuervorrichtung zur Regelung des Ladestromes oder der Ladespannung ausgebildet ist, die Steuervorrichtung zur schrittweisen Erhöhung der Ladespannung durch eingeprägte Strompulse oder Spannungspulse während einer vorgegebenen Ladezeit zwischen einer

Ladestartspannung gemäß dem Ladezustand der Batterie und der Ladeschlussspannung ausgebildet ist, und eine Einrichtung zur Messung oder Berechnung des Innenwiderstandes der Batterie in den Pausen zwischen zwei Pulsen des Ladestromes oder der Ladespannung vorgesehen ist, welche mit der Steuervorrichtung verbunden ist, sodass eine Anpassung des Ladestromes oder der Ladespannung an den gemessenen Innenwiderstand durchführbar ist. Eine derartige Batterieladevorrichtung ist besonders einfach und kostengünstig realisierbar. Beispielsweise kann eine derartige Batterieladevorrichtung mit gegebener Regelgenauigkeit durch ein entsprechendes Update der Software der Steuervorrichtung realisiert werden. Die Eingabe der gewünschten Ladezeit kann über die übliche Ein-/Ausgabeeinrichtung erfolgen.

Für eine optimale Ein- und Ausgabemöglichkeit und flexible Anpassungsfähigkeit an die jeweiligen Erfordernisse ist es von Vorteil, wenn die Ein-/Ausgabeeinrichtung durch einen Touchscreen gebildet ist.

Zu weiteren Merkmalen und Vorteilen einer Batterieladevorrichtung zur Ausführung des obigen Batterieladeverfahrens wird auf die obige Beschreibung des Ladeverfahrens und die nachfolgende Beschreibung von Ausführungsbeispielen verwiesen.

Die vorliegende Erfindung wird anhand der beigefügten Zeichnungen näher erläutert. Darin zeigen:
- Fig. 1: ein Blockschaltbild einer Vorrichtung zum Laden einer Batterie;
- Fig. 2: der übliche Verlauf des Innenwiderstands einer Blei-Säure-Batterie in Abhängigkeit des Ladezustands und Alters der Batterie;
- Fig. 3: ein schematisches Zeitdiagramm eines Ladeverfahrens;
- Fig. 4: die Verläufe des Ladestroms, der Ladespannung und des Innenwiderstands einer Batterie in Abhängigkeit des Ladezustands bei einem konventionellen Ladeverfahren mit konstantem Strom;
- Fig. 5: die Verläufe des Ladestroms, der Ladespannung und des Innenwiderstands eine Batterie in Abhängigkeit des Ladezustands;
- Fig. 6: eine Variante des Ladeverfahrens mit einer Spannungsrampe mit unterschiedlichen Steigungen;
- Fig. 7: die Verläufe des Ladestroms, der Ladespannung und des Innenwiderstands eine Batterie in Abhängigkeit des Ladezustands bei verschiedenen Alterungszuständen der Batterie;
- Fig. 8: eine Alternative des Ladeverfahrens mit Strompulsen; und
- Fig. 9: die zeitlichen Verläufe des Ladestroms und der Ladespannung der Batterie bei einem Beispiel des erfindungsgemäßen Ladeverfahrens.

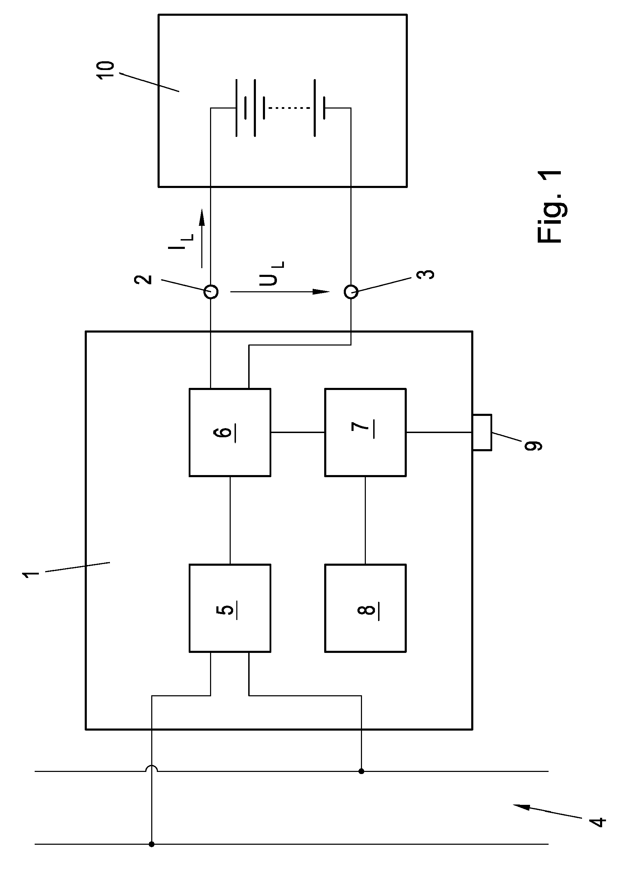

Fig. 1 zeigt ein Blockschaltbild einer Vorrichtung 1 zum Laden einer Batterie 10. Die Batterieladevorrichtung 1 umfasst Anschlüsse 2 und 3 zur Verbindung mit der aufzuladenden Batterie 10. Üblicherweise wird die Batterieladevorrichtung 1 mit dem Wechselspannungsnetz 4 verbunden und die Wechselspannung des Wechselspannungsnetzes 4 in einem entsprechenden Wandler 5 umgewandelt. In einer Ladeschaltung 6, die verschiedenartig ausgebildet sein kann, wird der für die Batterie 10 erforderliche Ladestrom I_{L} und die Ladespannung U_{L} erzeugt. Eine Steuervorrichtung 7, welche beispielsweise durch einen Mikroprozessor gebildet sein kann, übernimmt die Steuerung der Ladeschaltung 6. Über eine Ein-/Ausgabeeinrichtung 8, welche beispielsweise durch einen Touchscreen gebildet sein kann, erfolgt die Eingabe erforderlicher Parameter und die Ausgabe bzw. Anzeige von Informationen über den Ladevorgang. Über eine Schnittstelle 9, welche mit der Steuervorrichtung 7 verbunden ist, können Daten ausgelesen bzw. in die Batterieladevorrichtung 1 geladen werden. Beispielsweise kann die Schnittstelle 9 durch eine USB (Universal Serial Bus)-Schnittstelle gebildet sein, über welche auch Updates der Software der Steuervorrichtung 7 vorgenommen werden können. Ebenso kann die Schnittstelle 9 durch ein Ethernet-Schnittstelle oder dergleichen gebildet sein, über welche die Batterieladevorrichtung 1 mit einem Netzwerk, insbesondere dem Internet, verbunden werden kann.

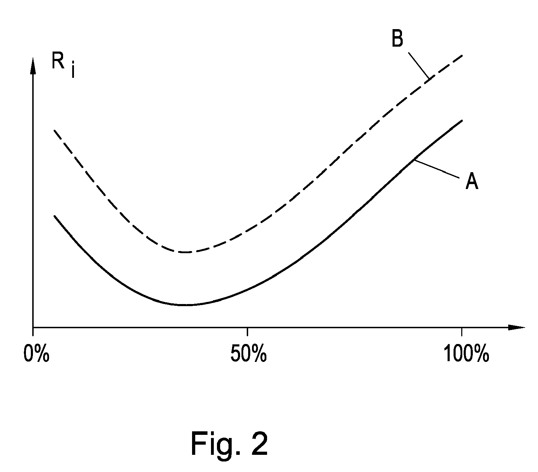

Fig. 2 zeigt den üblichen Verlauf des Innenwiderstands Rᵢ einer Blei-Säure-Batterie in Abhängigkeit des Ladezustands und Alters der Batterie. Die Kurve A zeigt den Innenwiderstand Rᵢ einer Blei-Säure-Batterie in Abhängigkeit des Ladezustands für eine neue Batterie. Bei einem mittleren Ladezustand (hier etwa 40%) weist der Innenwiderstand Rᵢ ein Minimum auf. Sowohl bei einem niedrigeren Ladezustand als auch höheren Ladezustand steigt der Innenwiderstand Rᵢ aufgrund verschiedener chemischer Reaktionen in der Batterie an. Wird die Batterie, wie üblich, mit einem konstanten Strom geladen, ohne auf den jeweiligen Innenwiderstand Rᵢ der Batterie Rücksicht zu nehmen, entstehen beim Ladevorgang relativ hohe Verluste und die Batterie wird in einem erhöhten Ausmaß erwärmt. Die Erwärmung der Batterie führt wiederum zu erhöhter Korrosion der Batterie und zu einer Verringerung deren Lebensdauer (Arrhenius-Gesetz). Die Kurve B zeigt den Verlauf des Innenwiderstands Rᵢ einer älteren Batterie in Abhängigkeit des Ladezustands, die über der Kurve A der neuen Batterie angeordnet ist, da der Innenwiderstand Rᵢ mit dem Alter der Batterie steigt. Darüber hinaus existiert eine starke Abhängigkeit des Innenwiderstands Rᵢ von Batterien von der jeweiligen Erwärmung. Mit steigender Temperatur sinkt der Innenwiderstand Rᵢ der Batterie üblicherweise.

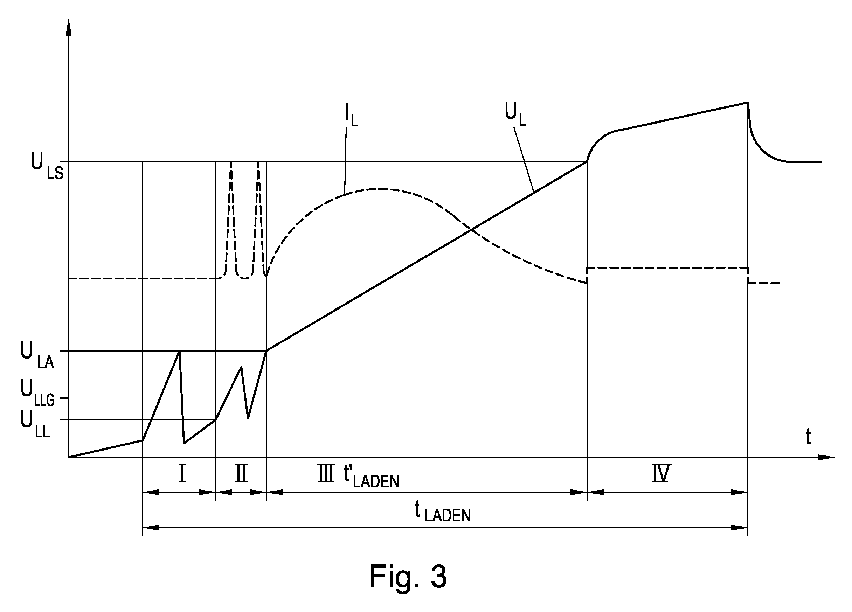

Fig. 3 zeigt ein schematisches Zeitdiagramm des Ladestroms I_{L} und der Ladespannung U_{L} eines Verfahrens zum Laden von Batterien. Das Ladeverfahren umfasst beispielsweise vier Phasen, die mit römischen Ziffern gekennzeichnet sind. In Phase I erfolgt die Ermittlung des Ladezustands der Batterie, indem beispielsweise die Leerlaufspannung U_{LL} ermittelt wird. Darüber hinaus wird in der Testprozedur überprüft, ob die Batterieladevorrichtung den benötigten Ladestrom I_{L} zum Laden der Batterie über die eingestellte bzw. vorgegebene Ladezeit t'_{Laden} überhaupt zur Verfügung stellen kann. Dies geschieht durch Anlegen von Spannungsrampen vor Beginn der Ladephase III. Die Dauer der Spannungsrampen steht in einem gewissen Verhältnis zur vorgegebenen Ladezeit t'_{Laden}. Die Spannungsrampen können ein- oder mehrmals wiederholt werden und am Ende der Spannungsrampe wird der Strom gemessen. Anhand des gemessenen Stroms lässt sich der maximale Ladestrom I_{L} in der Ladephase III abschätzen. Kann der Ladestrom I_{L} von der Batterieladevorrichtung nicht zur Verfügung gestellt werden, muss die definitive Ladezeit t'_{Laden} entsprechend erhöht werden. Dies kann beispielsweise durch Anzeigen eines unteren Grenzwerts für die Ladezeit t_{Laden,min} an der Batterieladevorrichtung vorgegeben werden.

Vor der eigentlichen Ladephase III (Hauptladephase) kann eine Depolarisation der Batterie gemäß Phase II vorgenommen werden. Diese Phase wird insbesondere dann durchgeführt, wenn die Leerlaufspannung U_{LL} der Batterie unter einem bestimmten Grenzwert U_{LLG} liegt. Während der Depolarisationsphase II werden Spannungsrampen an die Batterie angelegt, wodurch ein verschobenes Elektrodenpotential der Batterie ins Gleichgewicht gerückt werden kann. Die Dauer der Depolarisationsphase II wird als Bruchteil der effektiven Ladezeit t'_{Laden} gewählt. Nach Abschluss der Depolarisationsphase II beginnt der eigentliche Ladevorgang III. Die nach der Depolarisationsphase II resultierende Spannung der Batterie ist nunmehr die Ladestartspannung U_{LA} der Ladephase III. Wird keine Depolarisationsphase II vorgenommen, würde die Leerlaufspannung U_{LL} der Batterie als Ladestartspannung U_{LA} herangezogen.

Die Ladespannung U_{L} wird während der Ladezeit t'_{Laden} zwischen der Ladestartspannung U_{LA} und der durch die Batterie festgelegten Ladeschlussspannung U_{LS} erhöht. Die Ladeschlussspannung U_{LS} ist abhängig von der verwendeten Batterietechnologie, der Anzahl der Zellen sowie der Batterietemperatur. Im dargestellten Beispiel wird die Ladespannung U_{L} kontinuierlich und linear zwischen der Ladestartspannung U_{LA} und der Ladeschlussspannung U_{LS} während der Ladezeit t'_{Laden} erhöht. Um einen derartigen linearen Verlauf der Ladespannung U_{L} zu erreichen, muss der Ladestrom I_{L} oder die Ladespannung U_{L} entsprechend geregelt werden, sodass sich der gewünschte Verlauf der Ladespannung U_{L}, wie dargestellt, ergibt. Durch die entsprechende Regelung erfolgt indirekt eine Berücksichtigung des Innenwiderstands Rᵢ der Batterie, ohne dass dieser aber wirklich gemessen wird. Durch die Berücksichtigung des sich ändernden Innenwiderstands R_{I} während des Ladevorgangs III können die Ladungsverluste und somit die Erwärmung der Batterie deutlich reduziert werden. In der Folge kann die Batterielebensdauer entsprechend erhöht werden. Die definitive Zeit t'_{Laden} des Hauptladevorgangs III ist ein Bruchteil der insgesamt zur Verfügung stehenden Ladezeit t_{Laden}, beispielsweise 50-80% davon. Die Nettozeit für den Ladevorgang III wird mit t'_{Laden} gekennzeichnet.

Nach Abschluss des Hauptladeverfahrens in Phase III kann noch ein Nachladevorgang IV zur Vollladung angeschlossen werden. Hier können verschiedene bekannte Verfahren zur Nachladung bzw. Vollladung der Batterie angewendet werden.

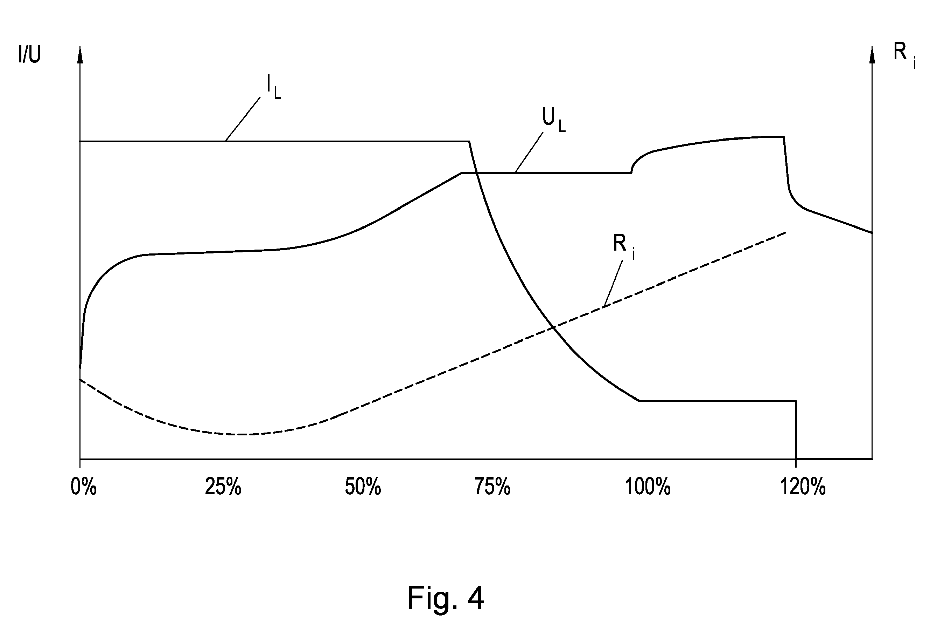

Fig. 4 zeigt die Verläufe des Ladestroms I_{L} der Ladespannung U_{L} und des Innenwiderstands Rᵢ einer Batterie in Abhängigkeit des Ladezustands bei einem konventionellen Ladeverfahren mit konstantem Ladenstrom I_{L}. Bei einem derartigen Standardladeverfahren wird die Batterie mit einem konstanten Ladestrom I_{L} geladen, weshalb sich ein entsprechender Verlauf für die Ladespannung U_{L} in Abhängigkeit des komplexen Innenwiderstands Rᵢ der Batterie ergibt. Während der Ladephase wird der sich ändernde Innenwiderstand Rᵢ der Batterie nicht berücksichtigt. Bis zu einer gewissen Ladespannung U_{L} bleibt der Ladestrom I_{L} konstant (stromkonstant) oder im Wesentlichen konstant (leistungskonstant). In der Folge entstehen während der Ladung unterschiedliche Ladungsverluste, die zu unterschiedlicher Erwärmung der Batterie führen, insbesondere zu erhöhter Erwärmung, welche die Lebensdauer der Batterie reduziert.

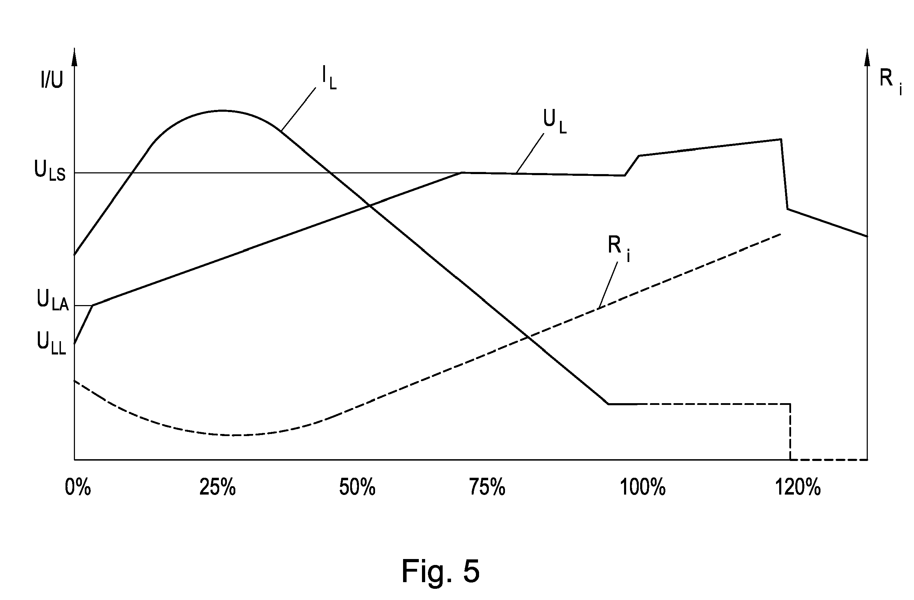

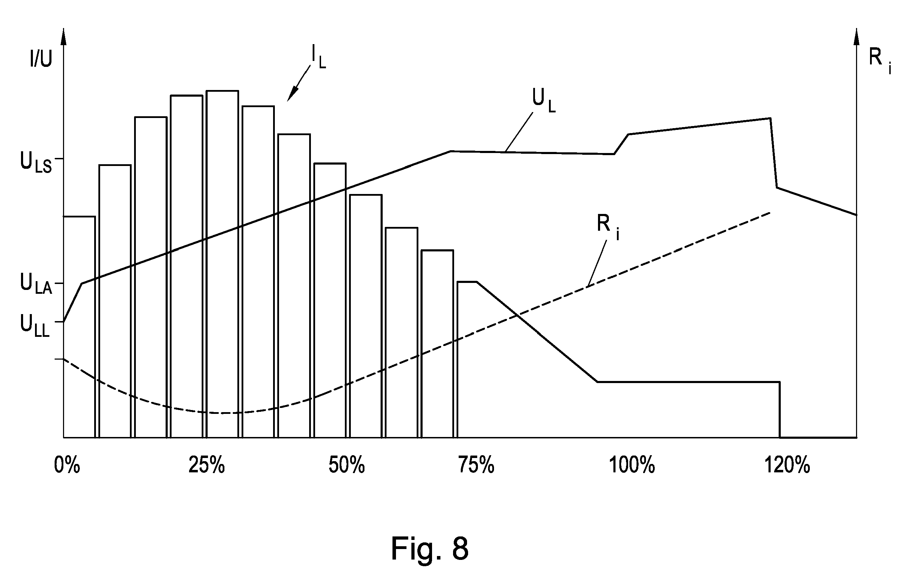

Im Vergleich dazu zeigt Fig. 5 die Verläufe des Ladestroms I_{L} der Ladespannung U_{L} und des Innenwiderstands Rᵢ einer Batterie in Abhängigkeit des Ladezustands. Nach der Testprozedur und allenfalls dem Depolarisationsvorgang, wird die Ladespannung U_{L} von der Ladestartspannung U_{LA} der Batterie bis zur Ladeschlussspannung U_{LS} erhöht. Um einen derartigen Verlauf der Ladespannung U_{L} zu erzielen, muss der Ladestrom I_{L} entsprechend geregelt werden, wodurch eine Berücksichtigung des sich ändernden Innenwiderstands Rᵢ automatisch erfolgt. Somit resultiert ein Verlauf des Ladestroms I_{L}, der bei einem im Wesentlichen mittleren Ladezustand (hier etwa 30-40%) ein Maximum aufweist. Durch dieses Ladeverfahren können die Verluste während des Ladens reduziert und somit auch die Batterieerwärmung reduziert werden, was positiven Einfluss auf die Batterielebensdauer hat. Während des Ladevorgangs wird der Innenwiderstand Rᵢ der Batterie nicht gemessen. Im Gegensatz zu einem kontinuierlichen Anstieg der Ladespannung U_{L} kann diese aber auch über Strompulse oder Spannungspulse erhöht werden und zwischen den Strom- oder Spannungspulsen der Innenwiderstand Rᵢ der Batterie gemessen oder berechnet und der nächste Strompuls oder Spannungspuls an den gemessenen Innenwiderstand Rᵢ angepasst werden (siehe Fig. 8).

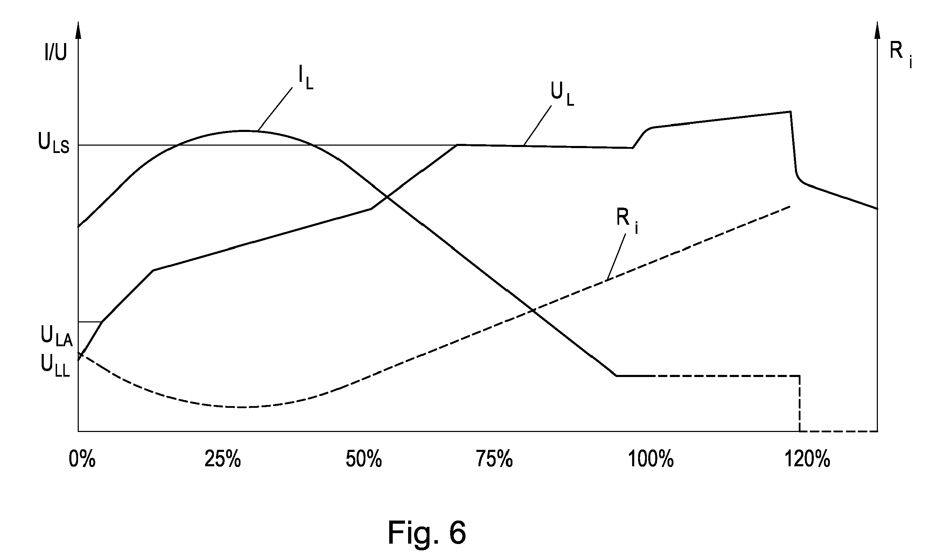

Fig. 6 zeigt eine Variante gegenüber dem Ladeverfahren gemäß Fig. 5, bei dem die Regelung des Ladestromes I_{L} oder der Ladespannung U_{L} derart erfolgt, dass die rampenförmige Ladespannung U_{L} verschiedene Teilabschnitte mit verschiedenen Steigungen aufweist. Im dargestellten Ausführungsbeispiel beginnt das Ladeverfahren mit einem steileren Anstieg der Ladespannung U_{L}, geht dann in einen Teilabschnitt mit geringerer Steigung über und endet wieder mit einem Abschnitt mit steilerem Anstieg der Ladespannung U_{L} bis zur Ladeschlussspannung U_{LS}. Durch eine derartige Abflachung der Rampe der Ladespannung U_{L} kann das Maximum des Ladestromes I_{L} bei minimalem Innenwiderstand Rᵢ reduziert werden. Dadurch ist ein Ladegerät mit geringerem maximalen Ladestrom I_{L} ausreichend.

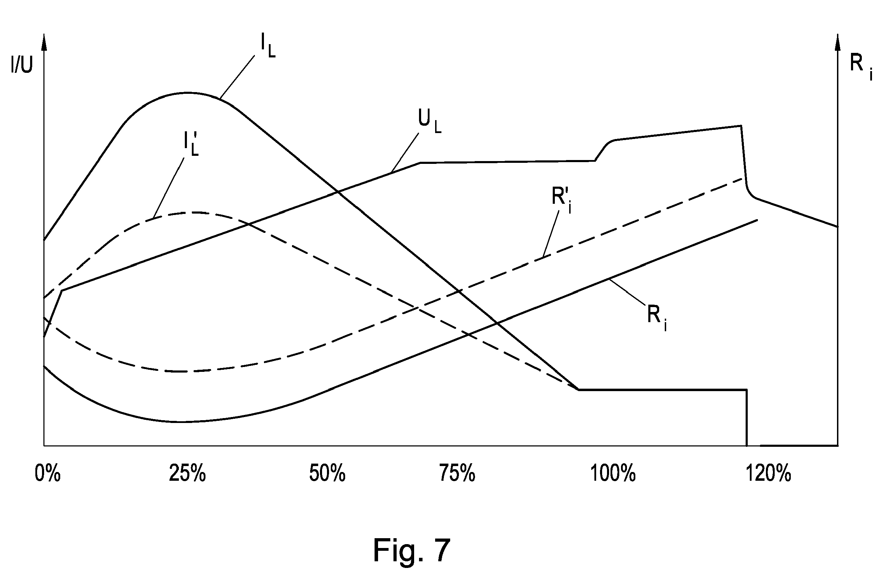

Fig. 7 zeigt die Verläufe des Ladestroms I_{L}, der Ladespannung U_{L} und des Innenwiderstands Rᵢ einer Batterie in Abhängigkeit des Ladezustands bei unterschiedlichem Alterungszustand der Batterie. Während bei einer neuwertigen Batterie der Innenwiderstand Rᵢ niedriger ist, steigt dieser im Laufe des Alters der Batterie entsprechend an. Die Kurve R'ᵢ zeigt den Verlauf des Innenwiderstands Rᵢ einer gealterten Batterie. Beim erfindungsgemäßen Ladeverfahren wird nun die Ladespannung U_{L} entsprechend eingeprägt und bleibt somit unverändert, egal wie alt die Batterie ist. Der Ladestrom I_{L} hingegen, der zur Erzielung des wunschgemäßen Verlaufs der Ladespannung U_{L} entsprechend geregelt wird, ist bei einer gealterten Batterie aufgrund des höheren Innenwiderstands R'ᵢ entsprechend reduziert. Dies wird durch den Verlauf des Ladestroms I'_{L} veranschaulicht.

Fig. 8 zeigt die Verläufe des Ladestromes I_{L}, der Ladespannung U_{L} und des Innenwiderstands Rᵢ einer Batterie in Abhängigkeit des Ladezustands beim erfindungsgemäßen Ladeverfahren unter Anwendung von Strompulsen, welche zur Erzielung des rampenförmigen Verlaufs der Ladespannung U_{L} entsprechend geregelt werden. Dabei ist der Verlauf der Ladespannung U_{L} nur schematisch dargestellt.

In der Realität wird die Ladespannung U_{L} nicht linear ansteigen, sondern entsprechend der Pulse des Ladestromes I_{L} Veränderungen aufweisen. In den Pausen zwischen zwei Strompulsen wird der Innenwiderstand Rᵢ gemessen und in die Regelung des Ladestromes I_{L} miteinbezogen, indem der Ladestrom I_{L} in Abhängigkeit des gemessenen Innenwiderstands Rᵢ geregelt wird. Zur Messung des Innenwiderstands Rᵢ ist eine Absenkung des Stroms auf einen bestimmten Wert ausreichend; es ist nicht erforderlich den Strom auf Null zu reduzieren. Zur Erfassung des komplexen Innenwiderstands Rᵢ der Batterie wird die Spannungsantwort während einer bestimmten Zeit erfasst und daraus der Innenwiderstand Rᵢ berechnet. Anstelle von Strompulsen können auch Spannungspulse eingeprägt werden. Diese Variante ist jedoch von der Regelung aufwendiger.

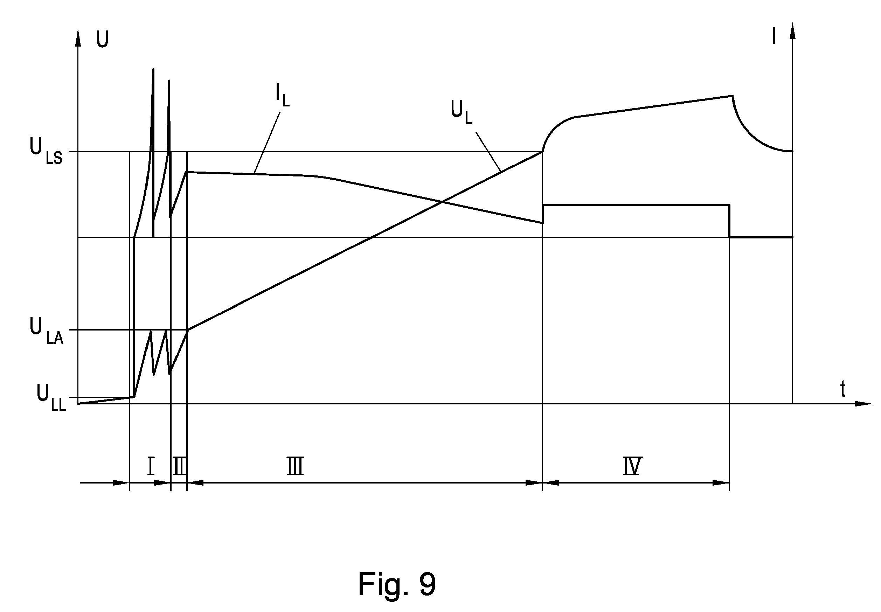

Schließlich zeigt Fig. 9 noch die zeitlichen Verläufe des Ladestroms I_{L} und der Ladespannung U_{L} der Batterie bei einem Beispiel des erfindungsgemäßen Ladeverfahrens. Während der Ladephase III sinkt der Ladestrom allmählich ab, wodurch die Verluste während der Ladung reduziert werden können.

Das erfindungsgemäße Ladeverfahren bewirkt einen erhöhten Gesamtwirkungsgrad und aufgrund der dadurch verringerten Temperaturerhöhung, eine Verlängerung der Batterielebensdauer und somit eine Verlängerung der Einsatzfähigkeit der Batterie, beispielsweise in einem Flurförderzeug. In der Folge kommt es in der Batterie auch zu weniger Wasserverlust. Durch die optimale Ausnutzung der gesamten Ladezeit t_{Laden} bzw. Nettoladezeit t'_{Laden} kann die Batterie schonend geladen werden. Durch Ausnutzung von Zeiten, in welchen Energie billiger ist, beispielsweise Nachtstrom, kann es auch zu weiteren wirtschaftlichen Vorteilen kommen. Beispielsweise kann auch vor Einleitung der Ladephase eine Verzögerung um eine Zeitspanne Δtᵥ vorgenommen werden (nicht dargestellt).

## Patentansprüche

1. Verfahren zum Laden von Batterien (10), insbesondere Blei-Säure-Batterien, mit einer vorgegebenen Ladeschlussspannung (U_{LS}), wobei vor dem Ladevorgang der Ladezustand der Batterie (10) festgestellt wird, und die Batterie (10) während des Ladevorgangs mit einem Ladestrom (I_{L}) oder einer Ladespannung (U_{L}) beaufschlagt wird, **dadurch gekennzeichnet, dass** die Ladespannung (U_{L}) während einer vorgegebenen Ladezeit (t'_{Laden}) durch eingeprägte Strompulse oder Spannungspulse zwischen einer Ladestartspannung (U_{LA}) gemäß dem Ladezustand der Batterie (10) und der Ladeschlussspannung (U_{LS}) schrittweise erhöht wird, und in den Pausen zwischen zwei Strompulsen oder Spannungspulsen der Innenwiderstand (Rᵢ) der Batterie (10) gemessen wird, und der Ladestrom (I_{L}) oder die Ladespannung (U_{L}) so geregelt wird, dass der Ladestrom (I_{L}) oder die Ladespannung (U_{L}) an den gemessenen Innenwiderstand (Rᵢ) angepasst wird.

2. Batterieladeverfahren nach Anspruch 1, **dadurch gekennzeichnet, dass** eine Meldung ausgegeben wird, wenn der zur Erzielung der Ladespannung (U_{L}) während der Ladezeit (t'_{Laden}) notwendige Ladestrom (I_{L}) oberhalb eines maximal möglichen Ladestroms (I_{L,max}) liegt.

3. Batterieladeverfahren nach Anspruch 1 oder 2, **dadurch gekennzeichnet, dass** ein unterer Grenzwert für die Ladezeit (t_{Laden,min}) angezeigt wird, innerhalb welchem das Laden der Batterie (10) mit dem maximal möglichen Ladestrom (I_{L,max}) bis zum Erreichen der Ladeschlussspannung (U_{LS}) möglich ist.

4. Batterieladeverfahren nach einem der Ansprüche 1 bis 3, **dadurch gekennzeichnet, dass** der Ladezustand der Batterie durch Messung der aktuellen Leerlaufspannung (U_{LL}) festgestellt wird.

5. Batterieladeverfahren nach Anspruch 4, **dadurch gekennzeichnet, dass** die Batterie (10) vor dem Ladevorgang die Batterie (10) depolarisiert wird, wenn die Leerlaufspannung (U_{LL}) unter einem vorgegebenen Grenzwert (U_{LLG}) liegt, indem der Ladestrom (I_{L}) oder die Ladespannung (U_{L}) derart geregelt wird, dass eine Spannungsrampe zwischen der Leerlaufspannung (U_{LL}) der Batterie und einer definierten Depolarisationsspannung (U_{LD}) erzeugt wird.

6. Batterieladeverfahren nach Anspruch 5, **dadurch gekennzeichnet, dass** die Depolarisations-Spannungsrampe zumindest einmal wiederholt wird.

7. Batterieladeverfahren nach einem der Ansprüche 1 bis 6, **dadurch gekennzeichnet, dass** nach dem Ladevorgang mit Erreichen der Ladeschlussspannung (U_{LS}) eine Nachladung vorgenommen wird.

8. Batterieladeverfahren nach einem der Ansprüche 1 bis 7, **dadurch gekennzeichnet, dass** die Ladezeit (t'_{Laden}) als Differenz eines vorgegebenen Endzeitpunkts (t_{E}) des Ladevorgangs und der aktuellen Zeit (tₐₖₜ) ermittelt wird.

9. Batterieladeverfahren nach einem der Ansprüche 1 bis 8, **dadurch gekennzeichnet, dass** die vorgegebene Ladezeit (t'_{Laden}) auf einen Bruchteil, insbesondere auf 50% bis 90% der Ladezeit (t_{Laden}) reduziert wird.

10. Batterieladeverfahren nach einem der Ansprüche 1 bis 9, **dadurch gekennzeichnet, dass** der Beginn des Ladevorgangs um eine Zeitspanne (Δtᵥ) verzögert wird.

11. Batterieladeverfahren nach Anspruch 10, **dadurch gekennzeichnet, dass** eine maximal mögliche Zeitspanne (Δt_{v,max}) für die Verzögerung des Ladevorgangs vorgeschlagen und angezeigt wird.

12. Vorrichtung (1) zum Laden von Batterien (10), insbesondere Blei-Säure-Batterien, mit einer vorgegebenen Ladeschlussspannung (U_{LS}), mit Anschlüssen (2, 3) zur Verbindung mit der Batterie (10), mit einer Ein-/Ausgabeeinrichtung (8) und einer Steuervorrichtung (7), wobei eine Einrichtung zur Feststellung des Ladezustand der Batterie (10) vorgesehen ist, weiters an der Ein-/Ausgabeeinrichtung (8) die Ladezeit (t_{Laden}) vorgebbar ist, **dadurch gekennzeichnet, dass** die Steuervorrichtung (7) zur Regelung des Ladestromes (I_{L}) oder der Ladespannung (U_{L}) ausgebildet ist, die Steuervorrichtung (7) zur schrittweisen Erhöhung der Ladespannung (U_{L}) durch eingeprägte Strompulse oder Spannungspulse während einer vorgegebenen Ladezeit (t'_{Laden}) zwischen einer Ladestartspannung (U_{LA}) gemäß dem Ladezustand der Batterie und der Ladeschlussspannung (U_{LS}) ausgebildet ist, und dass eine Einrichtung zur Messung oder Berechnung des Innenwiderstands (Rᵢ) der Batterie (10) in den Pausen zwischen zwei Pulsen des Ladestromes (I_{L}) oder der Ladespannung (U_{L}) vorgesehen ist, welche mit der Steuervorrichtung (7) verbunden ist, sodass eine Anpassung des Ladestromes (I_{L}) oder der Ladespannung (U_{L}) an den gemessenen Innenwiderstand (Rᵢ) durchführbar ist.

13. Batterieladevorrichtung (1) nach Anspruch 12, **dadurch gekennzeichnet, dass** die Einrichtung zur Feststellung des Ladezustand der Batterie (10) durch eine Einrichtung zur Messung der aktuellen Leerlaufspannung (U_{LL}) der Batterie (10) gebildet ist.

14. Batterieladevorrichtung (1) nach Anspruch 12 oder 13, **dadurch gekennzeichnet, dass** die Ein-/Ausgabeeinrichtung (8) zur Eingabe eines Endzeitpunkts (t_{E}) des Ladevorgangs, zu welchem die Batterie (10) vollgeladen sein soll, ausgebildet ist, und dass die Steuervorrichtung (7) zur Ermittlung der Ladezeit (t_{Laden}) als Differenz des vorgegebenen Endzeitpunkts (t_{E}) des Ladevorgangs und der aktuellen Zeit (tₐₖₜ) ausgebildet ist.

15. Batterieladevorrichtung (1) nach einem der Ansprüche 12 bis 14, **dadurch gekennzeichnet, dass** die Steuervorrichtung (7) zur Verzögerung des Ladevorgangs um eine Zeitspanne (Δtᵥ) ausgebildet ist.
